# EUROPÄISCHE PATENTSCHRIFT

(11) **EP 1 282 349 B1**
(45) Veröffentlichungstag und Bekanntmachung des Hinweises auf die Patenterteilung: **26.01.2005**
(21) Anmeldenummer: 02014206.3
(22) Anmeldetag: 26.06.2002
(51) Int. Cl.: H05K 9/00

(54) **Frontteil für elektronische Steckbaugruppen**
Front panel for electronic plug in unit
Panneau frontal d'une unité électronique enfichable

(30) Priorität: 01.08.2001 DE 10137746
(43) Veröffentlichungstag der Anmeldung: 05.02.2003
(73) Patentinhaber: Schroff GmbH, D-75334 Straubenhardt (DE)
(72) Erfinder: Weiler, Hans-Jörg, 76275 Ettlingen (DE); Joist, Michael, 76571 Gaggenau (DE); Thalau, Klaus-Michael, 76316 Malsch (DE)
(74) Vertreter: Durm, Frank, Dipl.-Ing.

(56) Entgegenhaltungen:
- DE-A- 3 604 860

## Beschreibung

Die Erfindung bezieht sich auf ein Frontteil für elektromagnetisch abgeschirmte Baugruppen, die in Baugruppenträger eingeschoben werden, mit einer ebenen Frontplatte, die an ihren beiden Schmalseiten jeweils eine Längsnut aufweist.

Derartige Frontteile finden Anwendung beim Abdichten und Verschließen von Baugruppenträgern für elektronische Geräte, um die elektromagnetische Entkopplung des Baugruppenträgers von seiner Umgebung zu erreichen. Dabei soll zum einen die elektronische Baugruppe innerhalb des Baugruppenträgers vor externen elektromagnetischen Störungen geschützt werden. Zum anderen sollen die Emissionen der Baugruppe minimiert werden, so dass nur eine geringe Störung der Umgebung durch die Elektronik hervorgerufen wird. Deshalb ist eine hohe Schirmwirkung des Baugruppenträgers gegenüber hochfrequenten elektromagnetischen Wechselfeldern erforderlich.

Die Schwachstellen bei der elektromagnetischen Abschirmung sind die vertikalen Schlitze, die sich zwischen zwei benachbarten Frontteilen bzw. zwischen Frontteil und Gehäuserahmen ergeben. Die Breite der Schlitze hängt stark von den Toleranzen der in den Baugruppenträger eingesetzten Frontplatten ab. Zwischen den Frontplatten werden deshalb elastische Kontaktmittel eingefügt, die eine HF-dichte elektrische Kontaktierung der gegenüberliegenden Ränder zweier benachbarter Frontplatten bewirken sollen.

Aus der Patentschrift DE 195 44 835 C1 sind Frontplatten für Steckbaugruppen bekannt, die seitlich in ihren Schmalseiten eine Nut aufweisen, in der Federelemente befestigt sind. Die Federelemente weisen in Einschubrichtung und überragen die Dicke der Frontplatte. Derartige Kontaktfedern können beim Aus- und Einbau der Baugruppen durch den Benutzer leicht beschädigt werden. Sie haben weiterhin den Nachteil, dass die Kontaktfedern keine seitliche Führung aufweisen und deshalb nur einem begrenzten seitlichen Druck standhalten können.

Aus der DE 196 11 719 A1 ist eine Kontaktanordnung zum Herstellen einer HF-Dichtigkeit zwischen zwei, mit ihren Stirnseiten aneinandergrenzenden Frontplatten bekannt. Es werden dort verschiedene Dichtungselemente und Kontaktfedem vorgeschlagen. Aufgrund der Normvorgabe für die Frontplattendicke können jedoch nur sehr kleine Dichtungselemente eingesetzt werden, mit denen die Schlitze zwischen benachbarten Baugruppen nur unzureichend ausgefüllt werden können. Die vorgeschlagenen Kontaktfedern umgehen diese Problematik. Da sie die Dicke der Frontplatte in Einschubrichtung überragen, können die Kontaktfedern leicht während der Handhabung durch den Benutzer beim Ein- und Ausbau beschädigt werden.

Aus der Offenlegungsschrift DE 36 04 860 A1 sind einstückige, im Querschnitt U-förmige Frontplatten bekannt, deren zwei Seitenteile in Einschubrichtung weisen, wobei ein Seitenteil als Kontaktleiste und das andere als Gleitfederleiste zur Aufnahme von Federelementen ausgebildet ist.

Einstückige, im Querschnitt U-förmige Frontplatten werden üblicherweise aus Aluminium durch Strangpressen hergestellt. Dabei ist der Werkstoff starken Temperaturänderungen unterworfen, was zu Schrumpfung und unvorhergesehenen Maßänderungen führt. Auch das nachträgliche Ziehen (Recken) beeinflußt das Fertigungsmaß. Die gewünschte Breite der Frontplatten lässt sich deshalb nur mit großen Toleranzen erzielen. Je größer die Frontplatte ist, desto größer werden die Maßtoleranzen. Bei sehr breiten Frontplatten können die normativ vorgegebenen Toleranzen gar nicht mehr eingehalten werden.

Zur Herstellung von unterschiedlich breiten, einstückigen Frontplatten muss für jede Breite ein separates Werkzeug eingesetzt werden. Diese Vorgehensweise erfordert einen großen und vor allem kostenintensiven Aufwand.

Als weiterer Nachteil wird beim Strangpressen die Oberflächenstruktur und die Gefügestruktur des Materials verändert. Die Auswirkungen treten vor allem bei breiten und gleichzeitig dünnwandigen Frontplatten auf. Die Frontplatten lassen sich nicht mehr gleichmäßig eloxieren. Dies führt zu aufwendigen und kostspieligen Nachbearbeitungen. Ohne Nachbearbeitungen lässt sich keine qualitativ hochwertige, eloxierte Frontplatte herstellen.

Aufgabe der Erfindung ist die Schaffung eines Frontteils für HF-abgedichtete Baugruppenträger, welches geringe Maßtoleranzen hat, dessen Frontfläche problemlos eloxierfähig ist, und das in verschiedenen Breiten mit den gleichen Werkzeugen herstellbar ist.

Zur Lösung der Aufgabe wird von einer - an sich bekannten - ebenen Frontplatte ausgegangen, die an zwei Schmalseiten jeweils eine Nut trägt. Gelöst wird die Aufgabe erfindungsgemäß dadurch, dass an jeder Längsnut der beiden Schmalseiten der Frontplatte jeweils ein Schenkel eines im Querschnitt L-förmigen Seitenteils eingreift, wobei der zweite L-Schenkel in Einschubrichtung weist. Hierdurch entsteht ein im Querschnitt U-förmiges Frontteil.

Das erfindungsgemäße Frontteil lässt sich in beliebigen Breiten in einer hochwertigen, eloxierfähigen Qualität kostengünstig herstellen. Die ebenen Frontplatten können auf einfache Weise maßgenau geschnitten werden, so dass die in der Norm geforderten Toleranzen ohne teure Nacharbeit eingehalten werden können. Zur Herstellung unterschiedlich breiter Frontteile kann auf ein einziges Werkzeug für die Frontplatte zurückgegriffen werden, da die Form der Seitenteile unabhängig von der Breite der Frontplatte ist. Spezielle Werkzeuge werden nur für die profilierten Seitenteile benötigt, die jedoch relativ kleine Abmessungen haben. Die in die Längsnuten der Frontplatte eingreifenden Seitenteile können in Einschubrichtung noch während der Montage variiert werden, so dass eventuelle Toleranzen der Frontplatte und/oder der Seitenteile ausgeglichen werden können.

Die in Einschubrichtung weisenden freien L-Schenkel bieten eine große Fläche, die benötigt wird, um einen niederohmigen und niederinduktiven Kontakt zwischen zwei benachbarten Frontteilen zu gewährleisten. Zweckmäßig weisen die Längsnuten in den Schmalseiten der Frontplatte im wesentlichen rechtwinkliges Profil auf. Ein solches Profil lässt sich relativ leicht durch Fräsen oder Sägen herstellen.

Vorzugsweise ist in dem in die Längsnuten eingreifenden L-Schenkel der Seitenteile eine Vertiefung eingebracht. Damit kann die Verbindung zwischen der Frontplatte und dem Seitenteil verbessert werden. Besonders dann, wenn mittels eines Werkzeugs durch Verstemmen ein Formschluss zwischen der Frontplatte und dem Seitenteil hergestellt wird, erweist sich die Vertiefung im L-Schenkel als vorteilhaft.

Um eine dauerhafte Verbindung zwischen der Frontplatte und einem Seitenteil herzustellen, kann der in die Längsnut eingreifende L-Schenkel mit der Frontplatte verklebt werden.

Um ein Herausrutschen des L-Schenkels eines Seitenteils aus der Längsnut der Frontplatte zu vermeiden, kann der in die Längsnut eingreifende L-Schenkel in vorteilhafter Weise in die Längsnut eingepresst werden, so dass eine starre Verbindung zwischen der Frontplatte und dem L-Schenkel bewirkt wird.

In einer bevorzugten Ausführungsform ist der in Einschubrichtung weisende L-Schenkel eines Seitenteils als Dichtungsträger ausgebildet. Der Dichtungsträger ermöglicht die Aufnahme von elastischen leitfähigen Dichtungen oder von leitenden Kontaktfedern. Damit wird ein elektrischer HF-Kontakt zwischen zwei benachbarten Frontteilen oder zwischen einem Frontteil und der Gehäusewand des Baugruppenträgers hergestellt.

Der in Einschubrichtung weisende L-Schenkel eines Seitenteils kann auch als im wesentlichen ebene Kontaktfläche ausgebildet sein.

Besonders vorteilhaft erweist sich ein Frontteil, dessen eines Seitenteil einen in Einschubrichtung weisenden L-Schenkel aufweist, der als Kontaktfläche ausgebildet ist, und dessen zweites Seitenteil einen in Einschubrichtung weisenden L-Schenkel hat, der als Dichtungsträger ausgebildet ist.

Ein Ausführungsbeispiel der Erfindung wird nachstehend anhand der beigefügten Zeichnungen näher erläutert. Es zeigen:
- Fig. 1: einen Baugruppenträger mit mehreren Baugruppen;
- Fig. 2: einen Querschnitt durch das Frontteil eines der Baugruppenträger von Figur 1.

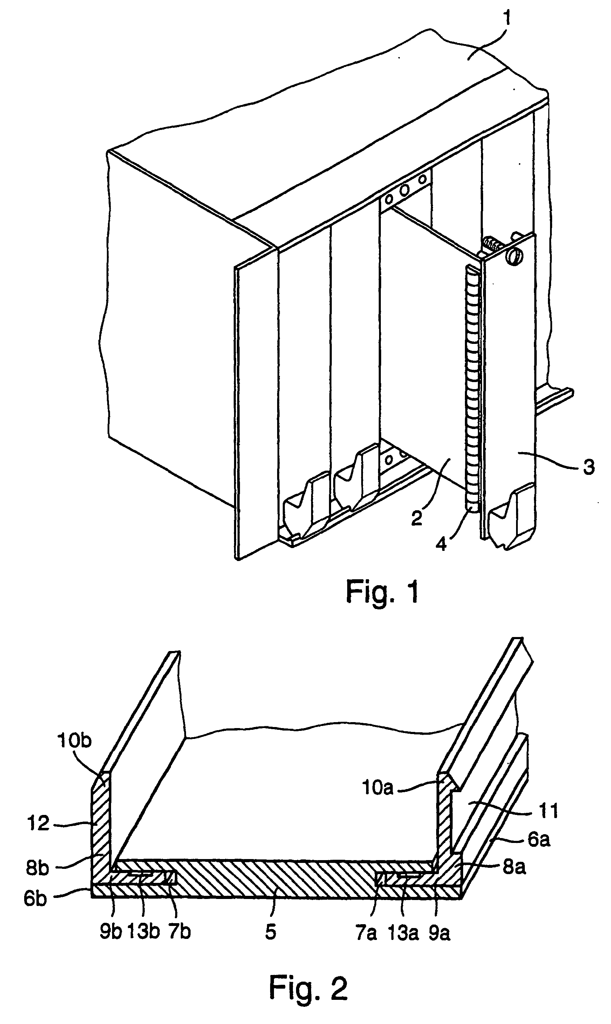

Figur 1 zeigt einen Baugruppenträger 1 mit mehreren, nebeneinander angeordneten Baugruppen, wobei eine der Baugruppen aus dem Baugruppenträger 1 teilweise herausgezogen ist. Die Baugruppe 2 weist ein Frontteil 3 auf, an deren linken Seite eine HF-Dichtung in Form einer Kontaktfederleiste 4 vorgesehen ist.

Figur 2 zeigt das Frontteil 3 der Baugruppe 2 aus Figur 1 im Querschnitt.

Eine ebene Frontplatte 5 trägt an ihren beiden Schmalseiten 6a, 6b jeweils eine Längsnut 7a, 7b. Die Längsnuten 7a, 7b weisen beide ein rechteckiges Profil auf.

Rechts und links der Frontplatte 5 sind zwei Seitenteile 8a, 8b angesetzt, die einen im wesentlichen L-förmigen Querschnitt haben. Die einen L-Schenkel 9a, 9b der Seitenteile 8a, 8b greifen in die Längsnuten 7a, 7b ein. Die anderen L-Schenkel 10a, 10b der Seitenteile 8a, 8b weisen jeweils in Einschubrichtung (vgl. Fig. 1).

Der in Einschubrichtung weisende Schenkel 10a des rechten Seitenteils 8a ist als Dichtungsträger ausgeführt. In einer Aussparung 11 können leitfähige Dichtungselemente oder Kontaktfedern aufgenommen werden, beispielsweise die Kontaktfederleiste 4 von Figur 1.

Der in Einschubrichtung weisende L-Schenkel 10b des linken Seitenteils 8b ist als ebene Kontaktfläche 12 ausgebildet. Sie stellt eine Anlagefläche für ein Dichtungselement oder eine Kontaktfeder eines benachbarten Frontteils 3 dar.

Die in die Längsnuten 7a, 7b eingreifenden L-Schenkel 9a, 9b der Seitenteile 8a, 8b weisen jeweils eine Vertiefung 13a, 13b auf.

Die beiden Seitenteile 8a, 8b sind mit ihren L-Schenkeln 9a, 9b in die jeweiligen Längsnuten 7a, 7b soweit eingeschoben, dass die beiden Seitenteile 8a, 8b im wesentlichen bündig mit der Frontplatte 5 abschließen.

### Zusammenstellung der Bezugszeichen

- 1: Baugruppenträger
- 2: Baugruppe
- 3: Frontteil
- 4: Kontaktfederleiste
- 5: Frontplatte
- 6a, 6b: Schmalseiten
- 7a, 7b: Längsnuten
- 8a, 8b: Seitenteile
- 9a, 9b: L-Schenkel
- 10a,10b: L-Schenkel
- 11: Aussparung
- 12: Kontaktfläche
- 13a, 13b: Vertiefungen

## Patentansprüche

1. Frontteil für elektromagnetisch abgeschirmte Baugruppen, die in Baugruppenträger eingeschoben werden, mit einer ebenen Frontplatte (5), die an ihren beiden Schmalseiten (6a, 6b) jeweils eine Längsnut (7a, 7b) aufweist, **gekennzeichnet durch** zwei angesetzte Seitenteile (8a, 8b), die im wesentlichen L-förmigen Querschnitt haben, wobei der eine L-Schenkel (9a, 9b) in eine Längsnut (7a, 7b) der Frontplatte (5) eingreift und der andere L-Schenkel (10a, 10b) in Einschubrichtung weist.

2. Frontteil nach Anspruch 1, **dadurch gekennzeichnet, dass** die Längsnuten (7a, 7b) rechteckiges Profil haben.

3. Frontteil nach Anspruch 1 oder 2, **dadurch gekennzeichnet, dass** der in eine Längsnut (7a, 7b) eingreifende L-Schenkel (9a, 9b) eine Vertiefung (13a, 13b) aufweist.

4. Frontteil nach einem der Ansprüche 1 bis 3, **dadurch gekennzeichnet, dass** die Frontplatte (5) und der in eine Längsnut (7a, 7b) eingreifende L-Schenkel (9a, 9b) formschlüssig miteinander verbunden sind.

5. Frontteil nach einem der Ansprüche 1 bis 3, **dadurch gekennzeichnet, dass** der in eine Längsnut (7a, 7b) eingreifende L-Schenkel (9a, 9b) mit der Frontplatte (5) verklebt ist.

6. Frontteil nach einem der Ansprüche 1 bis 3, **dadurch gekennzeichnet, dass** der in eine Längsnut (7a, 7b) eingreifende L-Schenkel (9a, 9b) in eine Längsnut (7a, 7b) der Frontplatte (5) eingepresst ist.

7. Frontteil nach einem der Ansprüche 1 bis 6, **dadurch gekennzeichnet, dass** der in Einschubrichtung weisende L-Schenkel (10a) eines Seitenteils (8a) als Dichtungsträger zur Aufnahme von Dichtungselementen oder Kontaktfedern ausgebildet ist.

8. Frontteil nach einem der Ansprüche 1 bis 7, **dadurch gekennzeichnet, dass** der in Einschubrichtung weisende L-Schenkel (10b) eines Seitenteils (8b) als im wesentlichen ebene Kontaktfläche (12) für ein Dichtungselement oder eine Kontaktfeder ausgebildet ist.

9. Frontteil nach einem der Ansprüche 1 bis 8, **dadurch gekennzeichnet, dass** die Außenseite der Frontplatte (5) bündig mit den in Einschubrichtung weisenden L-Schenkeln (10a, 10b) abschließt.

## Claims

1. Front part for electromagnetically shielded assemblies which are inserted into assembly carriers, with a flat front panel (5) which has a longitudinal groove (7a, 7b) on each of its two narrow sides (6a, 6b), **characterised by** two attached side parts (8a, 8b) which have a substantially L-shaped cross-section, wherein one arms of the L (9a, 9b) engages in a longitudinal groove (7a, 7b) in the front panel (5) and the other arm of the L (10a, 10b) points in the direction of insertion.

2. Front part as claimed in Claim 1, **characterised in that** the longitudinal grooves (7a, 7b) have a rectangular profile.

3. Front part as claimed in Claim 1 or 2, **characterised in that** the arm of the L (9a, 9b) which engages in a longitudinal groove (7a, 7b) has a recess (13a, 13b).

4. Front part as claimed in any one of Claims 1 to 3, **characterised in that** the front panel (5) and the arm of the L which engages in a longitudinal groove (7a, 7b) are connected to one another by interlocking.

5. Front part as claimed in any one of Claims 1 to 3, **characterised in that** the arm of the L (9a, 9b) which engages in a longitudinal groove (7a, 7b) is glued to the front panel (5).

6. Front part as claimed in any one of Claims 1 to 3, **characterised in that** the arm of the L (9a, 9b) which engages in a longitudinal groove (7a, 7b) is pressed into a longitudinal groove (7a, 7b) in the front panel (5).

7. Front part as claimed in any one of Claims 1 to 6, **characterised in that** the arm of the L (10a) which points in the direction of insertion is constructed as a seal support to receive sealing elements or a contact spring.

8. Front part as claimed in any one of Claims 1 to 7, **characterised in that** the arm of the L (10b) which belongs to a side part (8b) and points in the direction of insertion is constructed as a substantially flat contact surface (12) for a sealing element or a contact spring.

9. Front part as claimed in any one of Claims 1 to 8, **characterised in that** the outer face of the front panel (5) terminates flush with the arms of the L (10a, 10b) which point in the direction of insertion.

## Revendications

1. Panneau frontal pour unités à écran électromagnétique qui sont insérées dans des châssis, comportant une plaque frontale (5) plane qui présente sur chacun de ses deux côtés étroits (6a, 6b) une rainure longitudinale (7a, 7b), **caractérisé par** deux pièces latérales (8a, 8b) rapportées qui ont une section transversale essentiellement en forme de L, l'une des branches de L (9a, 9b) venant en prise dans une rainure longitudinale (7a, 7b) de la plaque frontale (5), et l'autre branche de L (10a, 10b) étant orientée dans la direction d'insertion.

2. Panneau frontal selon la revendication 1, **caractérisé en ce que** les rainures longitudinales (7a, 7b) ont un profil rectangulaire.

3. Panneau frontal selon la revendication 1 ou 2, **caractérisé en ce que** la branche de L (9a, 9b) venant en prise dans une rainure longitudinale (7a, 7b) présente un creux (13a, 13b).

4. Panneau frontal selon l'une des revendications 1 à 3, **caractérisé en ce que** la plaque frontale (5) et la branche de L (9a, 9b) venant en prise dans une rainure longitudinale (7a, 7b) sont reliées l'une à l'autre par correspondance de formes.

5. Panneau frontal selon l'une des revendications 1 à 3, **caractérisé en ce que** la branche de L (9a, 9b) venant en prise dans une rainure longitudinale (7a, 7b) est collée à la plaque frontale (5).

6. Panneau frontal selon l'une des revendications 1 à 3, **caractérisé en ce que** la branche de L (9a, 9b) venant en prise dans une rainure longitudinale (7a, 7b) est emprisonnée dans une rainure longitudinale (7a, 7b) de la plaque frontale (5).

7. Panneau frontal selon l'une des revendications 1 à 6, **caractérisé en ce que** la branche de L (10a) d'une pièce latérale (8a) orientée dans la direction d'insertion est réalisée comme support d'étanchéité pour recevoir des éléments d'étanchéité ou des ressorts de contact.

8. Panneau frontal selon l'une des revendications 1 à 7, **caractérisé en ce que** la branche de L (10b) d'une pièce latérale (8b) orientée dans la direction d'insertion est réalisée comme surface de contact (12) essentiellement plane pour un élément d'étanchéité ou un ressort de contact.

9. Panneau frontal selon l'une des revendications 1 à 8, **caractérisé en ce que** le côté extérieur de la plaque frontale (5) est aligné avec la branche de L (10a, 10b) orientée dans la direction d'insertion.
